(19)

Europäisches
Patentamt
European
Patent Office
Office européen
des brevets

(11)  **EP 4 001 853 A1**

(12)  **EUROPEAN PATENT APPLICATION**

(43) Date of publication:
    **25.05.2022 Bulletin 2022/21**

(21) Application number: **20208079.2**

(22) Date of filing: **17.11.2020**

(51) International Patent Classification (IPC):
    **G01D 5/14** *(2006.01)*     **G01D 5/244** *(2006.01)*
    **G01R 33/09** *(2006.01)*

(52) Cooperative Patent Classification (CPC):
    **G01D 5/145; G01D 5/24438; G01R 33/0005;**
    **G01R 33/091**

(84) Designated Contracting States:
    **AL AT BE BG CH CY CZ DE DK EE ES FI FR GB**
    **GR HR HU IE IS IT LI LT LU LV MC MK MT NL NO**
    **PL PT RO RS SE SI SK SM TR**
    Designated Extension States:
    **BA ME**
    Designated Validation States:
    **KH MA MD TN**

(71) Applicant: **Universität Wien**
    **1010 Vienna (AT)**

(72) Inventor: **The designation of the inventor has not yet been filed**

(74) Representative: **J A Kemp LLP**
    **80 Turnmill Street**
    **London EC1M 5QU (GB)**

(54) **MAGNETIC ENCODER AND METHOD OF DETECTING TRANSLATIONAL AND/OR ROTATIONAL DISPLACEMENT**

(57)    The disclosure relates to magnetic encoders for measuring translational and/or rotational displacement. In one arrangement, a magnetic scale provides a magnetic field that varies along a reference path. A read head can move along the reference path and has a sensor for detecting a magnetic field. The sensor provides an output that is dependent on an angle between a magnetization in a magnetically pinned layer and a magnetization in a magnetically free layer of the sensor. A sensor normal, defined as a normal to planes of layers in the sensor, is non-parallel to a local scale normal, defined as a normal to a portion of the magnetic scale facing the read head.

Fig. 1

EP 4 001 853 A1

**Description**

The invention relates to magnetic encoders for measuring translational and/or rotational displacement, and associated methods.

Various encoders are known for measuring translational and/or rotational displacements. The encoders may use optical, magnetic, inductive, capacitive and/or eddy current based effects.

Magnetic encoders typically comprise a magnetic scale and a read head. In some implementations the encoders may be referred to as linear encoders but magnetic encoders may also be used to measure rotational displacement. The magnetic scale typically provides a magnetic field that varies as a function of position along a reference path relative to the magnetic scale. The read head comprises one or more magnetic field sensors that can measure the magnetic field provided by the magnetic scale and thereby allow a position of the read head relative to the magnetic scale to be deduced.

It is an object of the invention to provide an improved magnetic encoder and associated methods.

According to an aspect of the invention, there is provided a magnetic encoder, comprising: a magnetic scale configured to provide a magnetic field that varies as a function of position along a reference path relative to the magnetic scale; and a read head configured to be moveable relative to the magnetic scale along the reference path, the read head comprising a sensor configured to detect a magnetic field and thereby provide an indication of an amount of displacement of the read head relative to the magnetic scale along the reference path, wherein: the sensor comprises a stack of layers having at least a magnetically pinned layer and a magnetically free layer; the sensor is configured to provide an output that is dependent on an angle between a magnetization in the magnetically pinned layer and a magnetization in the magnetically free layer; and the sensor is mounted such that a sensor normal, defined as a normal to planes of layers in the stack, is non-parallel to a local scale normal, defined as a normal to a portion of the magnetic scale facing the read head.

The pinned layer can be stabilized by an antiferromagnet. The pinned layer may also comprise two or more layers that are antiferromagnetically coupled, forming a synthetic antiferromagnet that may be coupled to an antiferromagnet. The direction of the pinned layer can be set by field annealing. If lasers are used for the annealing the field annealing can be realized locally, allowing for different pinned layer directions in different sensor elements.

Providing a magnetic encoder in which the sensor normal is non-parallel to the local scale normal reduces or avoids a limitation in prior art alternatives where saturation of the magnetically free layer can reduce, or cause complete loss of, sensitivity of the sensor for certain ranges of positions of the read head relative to the magnetic scale (e.g. when the read head is too close to the magnetic scale). The approach allows performance of the magnetic encoder to be less dependent on separation between the read head and the magnetic scale and/or provides greater flexibility in the range of separations that can be used (e.g. allowing the read head to be positioned closer to the magnetic scale than might otherwise be possible).

In an embodiment, the sensor is mounted such that the sensor normal is substantially perpendicular to the local scale normal. In an embodiment, the magnetically free layer has a shape that is rotationally symmetric about an axis parallel to the sensor normal. Orienting the planes of layers in this manner and/or arranging for the magnetically free layer to be rotationally symmetric provides particularly good sensitivity to changes in position of the read head relative to the magnetic scale and/or facilitates mapping of outputs from the sensor to corresponding amounts of displacement of the read head relative to the magnetic scale. The sensor can remain sensitive to changes in position or angle of the read head while the magnetically free layer remains in a saturated state. The direction of the saturated magnetization in the magnetically free layer follows changes in the direction of the externally applied magnetic field from the magnetic scale associated with changes in the position of the read head relative to the magnetic scale.

In an embodiment, the read head comprises a plurality of the sensors. This approach allows an output signal to be constructed by comparing outputs from different sensors, thereby improving sensitivity to small changes in displacement.

In an embodiment, the magnetic scale comprises a periodic magnetic arrangement that repeats along the reference path. In an embodiment, the sensors provided at different positions in the read head along the reference path are spaced apart evenly along the reference path, and a pitch of the periodic magnetic arrangement is an integer multiple of a pitch of the evenly spaced sensors. This arrangement allows for particularly enhanced sensitivity to small changes in displacement to be achieved by comparing outputs from different sensors.

In an embodiment, the directions of magnetization in the magnetically pinned layers of at least two of the sensors are different to each other. This approach allows high sensitivity to be achieved without spacing multiple sensors along the magnetic scale, for example at separations commensurate with a pitch of the magnetic scale. The read head can thus be made more compact. Furthermore, read head does not need to be adjusted for use with different magnetic scales. The same read head can be used for magnetic scales having different pitches and/or magnetic scales having irregular patterns of magnetisation.

According to a further aspect of the invention, there is provided a method of detecting translational and/or rotational displacement of a read head relative to a magnetic scale, wherein: the magnetic scale provides a magnetic field that varies as a function of position along a reference path relative to the magnetic scale; the read head comprises a sensor that detects an amount of displacement of the read head relative to the magnetic scale by detecting a magnetic field; the sensor comprises a stack of layers having at least a magnetically pinned layer and a magnetically free layer, an output of the sensor being dependent on an angle between a magnetization in the magnetically pinned layer and a magnetization in the magnetically free layer; and a sensor normal, defined as a normal to planes of layers in the stack, is non-parallel to a local scale normal, defined as a normal to a portion of the magnetic scale facing the read head.

The invention will now be further described, by way of example, with reference to the accompanying drawings, which are summarised below.

Figure 1 is a view along a z-direction of a magnetic encoder according to the prior art;
Figure 2 is a view along a y-direction of the magnetic encoder of Figure 1;
Figure 3 schematically depicts example magnetizations in a magnetically pinned layer and a magnetically free layer in a prior art sensor;
Figure 4 is a graph depicting a variation in a sensor output as a function of an x-component of an external magnetic field, Bx;
Figure 5 is a graph depicting variation with position along the x-direction of an x-component of a magnetic field (broken line) and an output from a sensor (solid line);
Figure 6 is a view along a y-direction of an exemplary magnetic encoder;
Figure 7 is a view along a z-direction of the magnetic encoder of Figure 6; and
Figure 8 schematically depicts example magnetizations in a magnetically pinned layer and a magnetically free layer in an exemplary sensor.
Figure 9 is a view along a y-direction of a further exemplary magnetic encoder.

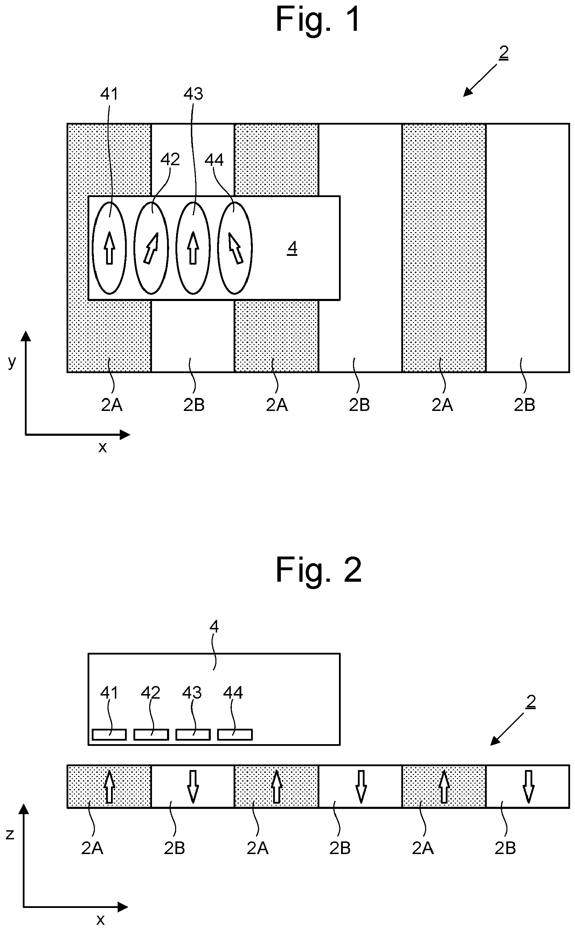

Figures 1 and 2 depict a magnetic encoder of the prior art. The magnetic encoder comprises a magnetic scale 2 and a read head 4. The magnetic scale 2 in this example comprises alternating regions 2A and 2B of +z and -z magnetization. The magnetization could equally alternate along +x and -x or along +y and -y. The read head 4 comprises sensors 41-44 that are capable of measuring a magnetic field. In the special example shown, the following magnetic field can be observed above the scale, which in the far field is to a good approximation given by:

$$B_x \approx B_{0,x} \cos\left(2\pi \frac{x}{2PP}\right)$$

$$B_z \approx B_{0,z} \sin\left(2\pi \frac{x}{2PP}\right)$$

$$(1.1)$$

Here *PP* is the width of the magnetic pole of the scale (pole pitch). For sufficient distance above the scale the following holds to a good approximation:

$$B_{0,x} \approx B_{0,z} \qquad\qquad (1.2)$$

Hence, to a good approximation the magnetic field can be regarded as a circular rotating field along the x-direction.

For standard magnetic encoders (linear or rotary) only one of these components is measured. In the case of a tunnel magnetoresistance (TMR) sensor, for example, the following relation holds for the conductivity $G_{\mathrm{TMR}}$, where *TMR* is the so called *TMR* ratio and $\theta$ the angle between the magnetically pinned layer and the magnetically free layer (which may be referred to as an unpinned layer):

$$G_{TMR} = \bar{G}\left(1 + \frac{TMR}{2}\cos\theta\right) \qquad\qquad (1.3)$$

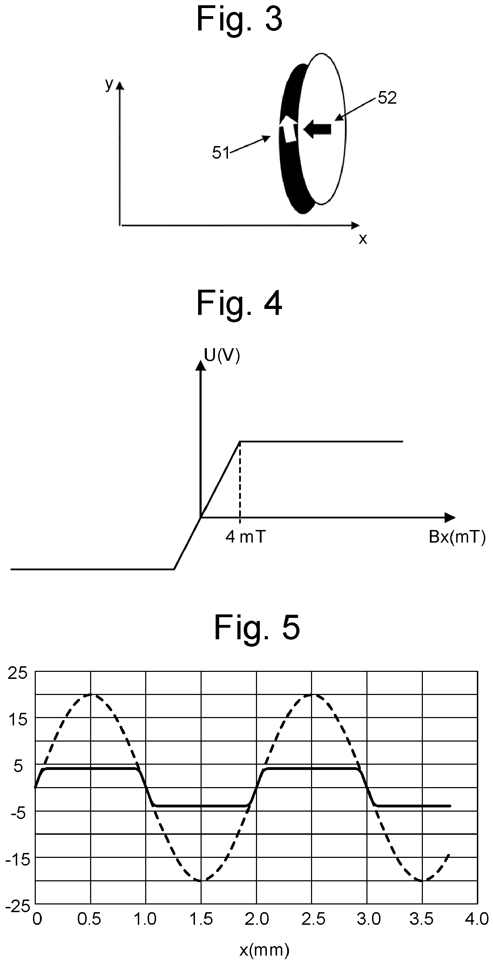

A possible configuration of a magnetically pinned layer 52 and a magnetically free layer 51 of one of the TMR sensors 41-44 is shown in Figure 3. The layers 51 and 52 are shown displaced slightly along the x-direction for ease of viewing, but in practice the layers would be aligned with each other along the z-direction. In the example shown, the magnetically pinned layer 52 is magnetized parallel to the x-direction. The pinned layer of sensor 41 and sensor 42 might be antiparallel. Also, the pinned layer of sensor 41 and sensor 43 might be antiparallel. Due to shape anisotropy the magnetically free layer 51 (depicted as elongate along the y-direction in Figure 1) has an effective easy axis along the y-direction (i.e. the most energetically favourable direction of spontaneous magnetization is along the y-direction). Hence, these sensors 41-44 are sensitive to magnetic fields along the x-direction. Atypical transfer curve is shown in Figure 4, where the vertical axis indicates a voltage output U from a sensor and the horizontal axis represents an x-component of the magnetic field, Bx. The transfer curved is flipped with respect to the voltage if the pinned layer is magnetized in the opposite direction.

In the configuration of the sensors 41-44 shown, it is possible to connect sensor 41 and sensor 43 in a Wheatstone bridge configuration. The same can be done for sensor 42 and sensor 44. As a consequence, the total output signal $S$ is evaluated as

$$S = \operatorname{atan}\left(\frac{G_{TMR,42} - G_{TMR,44}}{G_{TMR,41} - G_{TMR,43}}\right) \qquad (1.4)$$

where $S$ is proportional to the position of the scale as given by:

$$S = \operatorname{atan}\left(\frac{2\sin\left(2\pi\frac{x}{2PP}\right)}{2\cos\left(2\pi\frac{x}{2PP}\right)}\right) = 2\pi\frac{x}{2PP} = \frac{\pi x}{PP} \qquad (1.5)$$

A limitation of the above approach, however, is that the evaluation in Eq. 1.5 requires a linear response of the magnetic sensors 41-44. In practice, real sensors will be vulnerable to saturation for read head positions close to the magnetic scale. When this occurs, the output from the sensors 41-44 will become saturated for certain ranges of positions of the read head 4 relative to the magnetic scale 2, leading to loss of sensitivity over these ranges, as shown in Figure 5 for the case where the sensors 41-44 have the transfer curve shown in Figure 4 (i.e. saturating at 4 mT).

Embodiments of the present disclosure provide an improved magnetic encoder that is less vulnerable, or not vulnerable, to such loss of sensitivity.

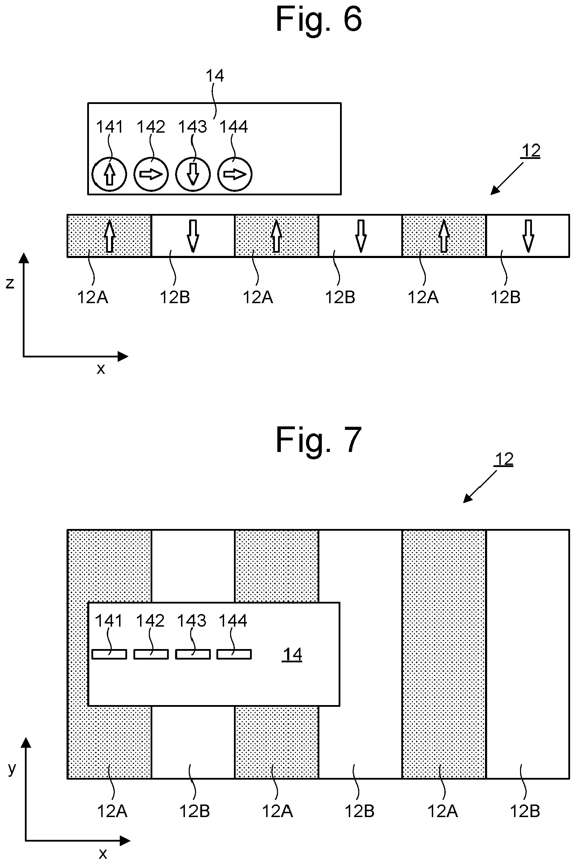

Magnetic encoders of the disclosure can be used for detection of translational (e.g. linear) displacement and/or for detection of rotational displacement (e.g. detection of an angle of rotation of an object). In the example of Figures 6 and 7, the magnetic encoder is configured to detect linear displacement. The magnetic encoder comprises a magnetic scale 12. The magnetic scale 12 provides a magnetic field that varies as a function of position along a reference path relative to the magnetic scale 12 (i.e. in the reference frame of the magnetic scale 12). The magnetic scale 12 may comprise a magnetization pattern along the reference path. For angle detection, the magnetization pattern may be coded for example along a curved reference path on a flat or curved surface (e.g. on a disk). The nature of the magnetization pattern is not particularly limited. Any known magnetic scale may be used with embodiments of the disclosure.

In the example shown in Figures 6 and 7, the portion of the reference path depicted is parallel to an x-direction of a Cartesian coordinate system. In the example shown, the magnetic scale 12 comprises a periodic magnetic arrangement that repeats along the reference path (i.e. parallel to the x-direction). The periodic magnetic arrangement comprises regions of opposite magnetization that alternate along the reference path. Regions 12A are permanently magnetized in the +z-direction (upwards in Figure 6). Adjacent regions 12B are permanently magnetized in the -z-direction (downwards in Figure 6). In other embodiments the magnetic scale 12 takes other forms, such as comprising pseudo random codes (PRC) codes or any other code for absolute position detection. Other coding systems may be used, including for example Nonius scales using two tracks.

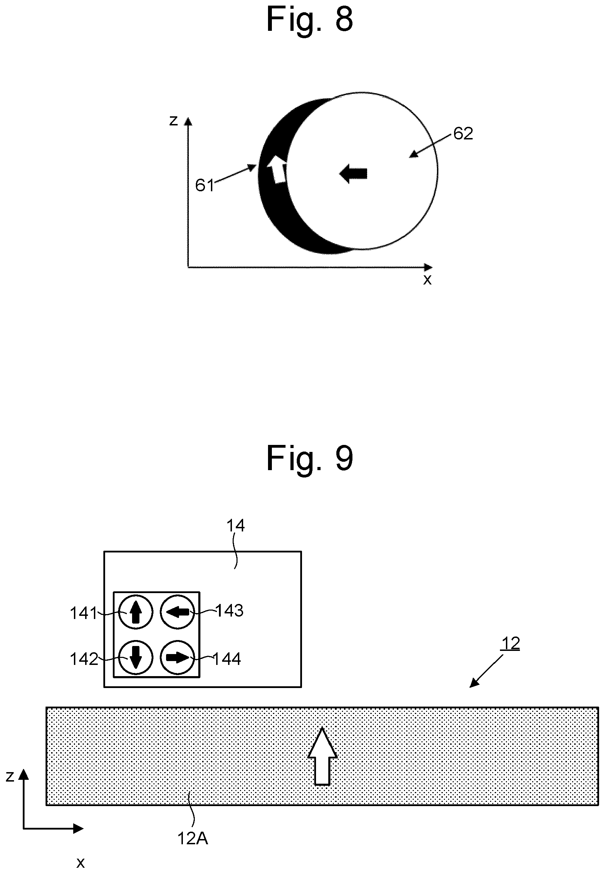

The magnetic encoder further comprises a read head 14. The read head 14 is configured to be moveable (linear motion and/or rotary motion) relative to the magnetic scale 12 along the reference path. The read head 14 may thus be moveably mounted relative to the magnetic scale 12. The read head 14 comprises at least one sensor 141-144. In the example shown, the read head 14 comprises four sensors 141-144. Each sensor 141-144 detects a magnetic field to indicate an amount of displacement of the read head 14 relative to the magnetic scale 12. In embodiments where the read head 14 comprises a plurality of the sensors 141-144, each of at least a subset of the sensors 141-144 may be provided at different positions in the read head along the reference path, as exemplified in Figures 6 and 7 where all of the sensors 141-144 are provided at different positions along the reference path. Alternatively, two or more of the sensors 141-144 may be positioned at substantially the same location along the reference path, as exemplified in Figure 9 discussed below.

Each sensor 141-144 comprises a stack of layers. The stack of layers comprises a plurality of layers stacked one on top of another. The stack of layers may be formed using photolithography techniques for example. The stack of layers comprises at least a magnetically pinned layer 62 and a magnetically free layer 61, as depicted schematically in Figure 8. As in the arrangement of Figure 3 (including magnetically pinned layer 52 and magnetically free layer 51), the layers 61 and 62 are shown displaced slightly along the x-direction for ease of viewing, but in practice the layers would be aligned with each other along the y-direction in embodiments of this type. Note that in contrast to Figure 3, the vertical axis in Figure 8 represents the z-direction rather than the y-direction. In the embodiment of Figures 6 and 7, the magnetically pinned layer 62 of all of the sensors 141-144 is aligned parallel to the x-direction as shown in Figure 8. The magnetization directions of the magnetically free layers 61 of the sensors 141-144 are indicated by the white filled arrows in the sensors 141-144 in Figure 6. The magnetization directions of the free layer are seen to follow the direction of the magnetic field just above the magnetic scale 12 as it varies along the reference path (along the x-direction). The pinned layer of all sensors 131-144 may point in the same direction, such as for example in the x-direction. Of course any other direction of the pinned layer within the x-z plane is also suitable.

Each sensor is configured to provide an output that is dependent on the angle between a magnetization in the magnetically pinned layer 62 and a magnetization in the magnetically free layer 61. This may be achieved, for example, by configuring each sensor 141-144 to comprise a magnetoresistance sensor in which the output of the sensor depends on an electrical resistivity of a layer between the magnetically pinned layer 62 and the magnetically free layer 61. The layer between the magnetically pinned layer 62 and the magnetically free layer 61 may be referred to as an interlayer. In some embodiments, each sensor 141-144 may comprise one or more of the following: an anisotropic magnetoresistance sensor (AMR); a giant magnetoresistance sensor (GMR); and a tunnel magnetoresistance sensor (TMR). In some embodiments, the sensors are provided in a spin valve structure. Here, a magnetic layer is pinned for example by an antiferromagnet (to provide a magnetically pinned layer). The magnetically pinned layer is separated by a tunnel barrier (TMR) or a spacer layer (GMR) from the magnetically free layer. The magnetization of the magnetically free layer is sensitive to the external field. The magnetically free layer may be configured to exhibit a shape anisotropy that favours a magnetization along the long axis. This long axis is preferably orthogonal to the pinned magnetization layer of the antiferromagnet. Instead of the shape anisotropy also a magneto crystalline anisotropy can be utilized to realize an orthogonal magnetization orientation between pinned layer and free layer at zero field. Other designs utilize a vortex magnetic state such as in Zimmer, Juergen, et al. "Device, magnetic sensor device and method." U.S. Patent Application No. 14/141,660. Unlike in embodiments of the present disclosure, however, in prior art implementations of a magnetic encoder, a film normal of the magnetic scale is always parallel to the film normal of the layer stack of the (e.g. GMR or TMR) sensor.

The interlayer may be a conductive, nonmagnetic layer, such as copper or non-conductor for TMR sensors. The resistivity of the layer stack may depend on the relative directions of magnetization of the magnetically pinned layer 62 and the magnetically free layer 61. For example, the resistivity may be relatively high when the magnetization of the magnetically pinned layer 62 is anti-parallel to the magnetization of the magnetically free layer 61 and relatively low when the magnetization of the magnetically pinned layer 62 is parallel to the magnetization of the magnetically free layer 61. Any magnetic material (e.g. a soft magnetic material) may be used to form the magnetically free layer and the magnetically pinned layer, including for example alloys of CoFe, CoFeB, and NiFe. The interlayer may be formed for example from MgO, AlO, Cu, Al or any other conducting or not conducting material that leads to a large GMR effect or large TMR effect.

In contrast to the arrangement described with reference to Figures 1-5, each sensor 141-144 is mounted such that a sensor normal, defined as a normal (i.e. a direction perpendicular to) planes of layers in the stack, is non-parallel with a local scale normal, defined as a normal to a portion (e.g. surface) of the magnetic scale 12 facing the read head 14. Typically, the magnetic scale 12 has a substantially planar, flat surface facing the read head 14. The magnetic scale 12 may, for example, comprise a strip- or plate-like element, with one face of the strip or plate forming the surface that faces the read head 14. Preferably, the sensor is mounted such that the angle between the sensor normal and the local scale normal is larger than 45°, optionally larger than 60°, optionally larger than 75°. Preferably, the sensor normal is substantially perpendicular to the local scale normal, as exemplified in Figures 6 and 7 (i.e. pointing along the y-direction rather than the z-direction). If rotary scales are used the local scale normal may point in different directions at different positions along the reference path (because the reference path is curved).

In Figure 6, the sensor normals of the sensors 141-144 point perpendicularly out of the page. In Figure 7, the sensor normals of the sensors 141-144 point upwards within the plane of the page (y-direction). In the arrangement described with reference to Figures 1-5, each sensor 41-44 was mounted with a sensor normal parallel to the facing surface of the magnetic scale 2, as shown in Figure 2. Arranging for the sensor normal to be non-parallel to the local scale normal eliminates the problem of saturation of the magnetically free layer 61. Furthermore it maximises the sensitivity of the sensor 141-144. Indeed, in the case where each sensor 141-144 is mounted such that the sensor normal is substantially perpendicular to the local scale normal, for example, the sensor 141-144 can be configured to operate with the magnetically free layer 61 always saturated (i.e. saturated for all positions of the read head 14 relative to the magnetic scale 12). When the magnetically free layer 61 is saturated, the magnetization of the magnetically free layer 61 may be substantially aligned with the magnetic field provided by the magnetic scale 12. Due to the strong shape anisotropy of the arrangement of Figures 1-5, the magnetically free layer 51 cannot point in the field direction but is located basically always within the sensor plane. In the present arrangement, in contrast, the saturated magnetically free layer 61 still has full sensitivity to changes in position of the read head 14 because such changes cause a change in the direction of the magnetization.

The above mechanism works particularly efficiently when the magnetically free layer 61 has a shape that is rotationally symmetric about an axis parallel to the sensor normal, as depicted schematically in Figure 8. Thus, when viewed along the normal to the planes of layers, the shape of the magnetically free layer 61 may appear circular (in contrast to the elongate shape of the magnetically free layer 51 of the sensors 41-44 of the arrangement of Figures 1-5). This rotational symmetry removes any shape anisotropy effects relative to the sensor normal, such that the magnetization in the plane of the magnetically free layer 61 freely follows the externally applied field (from the magnetic scale 12). Where the direction of the magnetic field provided by the magnetic scale 12 in the plane of the magnetically free layer 61 varies continuously as a function of position along the reference path, each sensor 141-144 will thus be sensitive to incremental changes in position of the read head 14 relative to the magnetic scale 12 at substantially all positions of the read head 14 relative to the magnetic scale 12 (in contrast to the situation described above with reference to Figure 5). The magnetization of the magnetically free layer may be a quasi uniform state. In other embodiments the magnetization of the free layer may be in a vortex state. In some embodiments, the sensor is provided with a perpendicular anisotropy with respect to the sensor plane. In this case the magnetization points parallel to the sensor normal if no external field is applied.

If the rotational symmetry was not present, the encoder could still operate, but the magnetization of the magnetically free layer 61 would no longer point exactly along the externally applied field (it would point in a direction between the externally applied field and an easy axis associated with the magnetic shape anisotropy). This could make interpretation of the output from the sensors 141-144 more complicated than necessary.

In some embodiments, as exemplified in Figures 6 and 7, the read head 14 comprises a plurality of the sensors 141-144 provided at different positions along the reference path and spaced apart evenly along the reference path. A pitch of the periodic magnetic arrangement of the magnetic scale 12 may be an integer multiple of a pitch of the evenly spaced sensors 141-144. In the example shown, the plurality of sensors 141-144 comprises four sensors 141-144 and the integer multiple is four.

In embodiments having plural sensors 141-144, a Wheatstone bridge arrangement that compares outputs from different sensors, preferably from sensors (e.g. 141 and 143 and/or 142 and 144) that are spaced apart from each other by a pitch equal to half the pitch of the periodic magnetic arrangement. In the example of Figures 6 and 7, the Wheatstone bridge may be configured to compare the outputs of sensors 142 and 144 and compare the outputs of sensors 141 and 143 to provide the following output signal $S$:

$$S = \mathrm{atan}\left(\frac{2\sin\left(2\pi\frac{x}{2PP}\right)}{2\cos\left(2\pi\frac{x}{2PP}\right)}\right) = 2\pi\frac{x}{2PP} = \frac{\pi x}{PP} \qquad (1.6)$$

Hence, an output signal is provided that is again proportional to the position of the read head 14 along the magnetic scale 12 in the x-direction (as in 1.5 above) but without the problem of saturation described above with reference to Figure 5.

In embodiments of the type described above with reference to Figures 6-8, the directions of magnetization in the magnetically pinned layers 62 of all or a subset of the sensors 141-144 provided at different positions in the read head 14 along the reference path are parallel to each other (all parallel to the x-direction in the example of Figures 6-8).

In an alternative embodiment, as exemplified in Figure 9, the read head 14 may be provided with a plurality of sensors 141-144 in which the directions of magnetization in the magnetically pinned layers 62 of at least two of (e.g. all or a subset of) the sensors 141-144 are different to each other (i.e. not pointing in the same direction). The directions of magnetization in the magnetically pinned layers 62 are indicated by the black filled arrows in Figure 9. The directions of magnetization may include at least two directions that are antiparallel to each other (e.g. sensors 141 and 142 and/or sensors 143 and 144). Additionally or alternatively, the directions of magnetization may include at least two directions that are perpendicular to each other (e.g. sensors 141 and 143, sensors 141 and 144, sensors 142 and 143, and/or sensors 142 and 144). In the example of Figure 9, the directions of magnetization include the following in a plane of each magnetically pinned layer 62 relative to a reference axis: 0 degrees (in sensor 141), 90 degrees (in sensor 144), 180 degrees (in sensor 142), 270 degrees (in sensor 143).

Magnetically pinned layers 62 having magnetizations pointing in different directions may be formed in various ways. The magnetically pinned layers 62 may for example be stabilized by exchange bias where the pinned layer is coupled to an antiferromagnet. In order to realize different pinned layer magnetization directions, laser annealing under different external field directions may be used. For example, in order to align the pinned layer in sensor 141, one heats this element by a laser and applies a field in +z direction. The sensors 141-144 may be positioned close enough together that the magnetization of the magnetically free layers 61 in the sensors 141-144 may all be substantially parallel to each other (as dictated by the external field direction in this location).

The free layer magnetization of the sensors 141-144 may point approximately into the same direction, since the distance of the sensors may be significant smaller than the pole pitch (as depicted in Figure 9).

In an embodiment, a Wheatstone bridge arrangement may be used to compare outputs from different sensors. The outputs of sensors 141 and 142 may be compared for example in order to measure a component of the magnetic field parallel to the z-axis. The outputs of sensors 143 and 144 may be compared to measure a component of the magnetic field parallel to the x axis. The combination of outputs from the sensors 141-144 can thus be used to provide a sensitive measure of the magnetic field direction above the magnetic scale. This approach allows high sensitivity to be achieved without spacing multiple sensors along the magnetic scale, for example at separations commensurate with a pitch of the magnetic scale. For example, in embodiments where the magnetic scale comprises a periodic magnetic arrangement that repeats along the reference path, the sensors 141-144 with non-parallel magnetizations in the magnetically pinned layers 62 may all be positioned within a length along the reference path that is smaller than a pitch of the periodic magnetic arrangement, preferably less than 50% of the pitch, preferably less than 25% of the pitch, preferably at substantially the same location. The read head 14 can thus be made more compact. Furthermore, read head 14 does not need to be adjusted for use with different magnetic scales. The same read head can be used for magnetic scales having different pitches and/or magnetic scales having irregular patterns of magnetisation.

The following numbered clauses define some embodiments of the disclosure.

1. A magnetic encoder, comprising:

a magnetic scale configured to provide a magnetic field that varies as a function of position along a reference path relative to the magnetic scale; and
a read head configured to be moveable relative to the magnetic scale along the reference path, the read head comprising a sensor configured to detect a magnetic field and thereby provide an indication of an amount of displacement of the read head relative to the magnetic scale along the reference path, wherein:

the sensor comprises a stack of layers having at least a magnetically pinned layer and a magnetically free layer;
the sensor is configured to provide an output that is dependent on an angle between a magnetization in the magnetically pinned layer and a magnetization in the magnetically free layer; and
the sensor is mounted such that a sensor normal, defined as a normal to planes of layers in the stack, is non-parallel to a local scale normal, defined as a normal to a portion of the magnetic scale facing the read head.

2. The encoder of clause 1, wherein:
the sensor is mounted such that the angle between the sensor normal and the local scale normal is larger than 45°.
3. The encoder of clause 1, wherein:
the sensor is mounted such that the sensor normal is substantially perpendicular to the local scale normal.
4. The encoder of any preceding clause, wherein:
the magnetically free layer has a shape that is rotationally symmetric about an axis parallel to the sensor normal.
5. The encoder of any preceding clause, wherein the sensor is configured so that the magnetically free layer is saturated, such that a magnetization of the magnetically free layer is substantially aligned with the magnetic field provided by the magnetic scale, for all positions of the read head relative to the magnetic scale.
6. The encoder of any preceding clause, wherein the direction of the magnetic field provided by the magnetic scale in the plane of the magnetically free layer varies continuously as a function of position along the reference path at substantially all positions of the read head relative to the magnetic scale.
7. The encoder of any preceding clause, wherein the sensor comprises a magnetoresistance sensor in which the output of the sensor is a function of an electrical resistivity of a layer between the magnetically pinned layer and the magnetically free layer, the electrical resistivity being a function of the relative directions of magnetization in the magnetically free layer and the magnetically pinned layer.
8. The encoder of clause 7, wherein the sensor comprises one or more of the following: an anisotropic magnetoresistance sensor, AMR; a giant magnetoresistance sensor, GMR; and a tunnel magnetoresistance sensor, TMR.
9. The encoder of any preceding clause, wherein the read head comprises a plurality of the sensors.
10. The encoder of clause 9, wherein at least a subset of the sensors are provided at different positions in the read head along the reference path.

11. The encoder of clause 10, wherein the directions of magnetization in the magnetically pinned layers of all or a subset of the sensors provided at different positions in the read head along the reference path are parallel to each other.

12. The encoder of clause 10 or 11, wherein the magnetic scale comprises a periodic magnetic arrangement that repeats along the reference path.

13. The encoder of clause 12, wherein the periodic magnetic arrangement comprises regions of opposite magnetization that alternate along the reference path.

14. The encoder of clause 12 or 13, wherein:

the sensors provided at different positions in the read head along the reference path are spaced apart evenly along the reference path; and

a pitch of the periodic magnetic arrangement is an integer multiple of a pitch of the evenly spaced sensors.

15. The encoder of clause 14, further comprising a Wheatstone bridge arrangement configured to compare outputs from different sensors, preferably from sensors that are spaced apart from each other by a pitch of the periodic magnetic arrangement.

16. The encoder of clause 14 or 15, wherein the plurality of sensors comprises at least four sensors and the integer multiple is four.

17. The encoder of clause 9, wherein the directions of magnetization in the magnetically pinned layers of at least two of the sensors are different to each other.

18. The encoder of clause 17, wherein the directions of magnetization in the magnetically pinned layers include at least two directions that are antiparallel to each other.

19. The encoder of clause 17 or 18, wherein the directions of magnetization in the magnetically pinned layers include at least two directions that are perpendicular to each other.

20. The encoder of any of clauses 17-19, wherein the directions of magnetization in the magnetically pinned layers include the following in a plane of each magnetically pinned layer relative to a reference axis: 0 degrees, 90 degrees, 180 degrees, 270 degrees.

21. The encoder of any of clauses 17-20, wherein:

the magnetic scale comprises a periodic magnetic arrangement that repeats along the reference path; and

two or more of the sensors with different directions of magnetization in the magnetically pinned layers are all positioned within a length along the reference path that is smaller than a pitch of the periodic magnetic arrangement.

22. The encoder of any of clauses 17-21, wherein two or more of the sensors with different directions of magnetization in the magnetically pinned layers are all positioned in the read head at substantially the same location along the reference path.

23. A method of detecting translational and/or rotational displacement of a read head relative to a magnetic scale, wherein:

the magnetic scale provides a magnetic field that varies as a function of position along a reference path relative to the magnetic scale;

the read head comprises a sensor that detects an amount of displacement of the read head relative to the magnetic scale by detecting a magnetic field;

the sensor comprises a stack of layers having at least a magnetically pinned layer and a magnetically free layer, an output of the sensor being dependent on an angle between a magnetization in the magnetically pinned layer and a magnetization in the magnetically free layer; and

a sensor normal, defined as a normal to planes of layers in the stack, is non-parallel to a local scale normal, defined as a normal to a portion of the magnetic scale facing the read head.

**Claims**

1. A magnetic encoder, comprising:

a magnetic scale configured to provide a magnetic field that varies as a function of position along a reference path relative to the magnetic scale; and

a read head configured to be moveable relative to the magnetic scale along the reference path, the read head comprising a sensor configured to detect a magnetic field and thereby provide an indication of an amount of displacement of the read head relative to the magnetic scale along the reference path, wherein:

the sensor comprises a stack of layers having at least a magnetically pinned layer and a magnetically free layer;

the sensor is configured to provide an output that is dependent on an angle between a magnetization in the magnetically pinned layer and a magnetization in the magnetically free layer; and

the sensor is mounted such that a sensor normal, defined as a normal to planes of layers in the stack, is non-parallel to a local scale normal, defined as a normal to a portion of the magnetic scale facing the read head.

2. The encoder of claim 1, wherein:
the sensor is mounted such that the angle between the sensor normal and the local scale normal is larger than 45°, optionally wherein the sensor normal is substantially perpendicular to the local scale normal.

3. The encoder of any preceding claim, wherein:
the magnetically free layer has a shape that is rotationally symmetric about an axis parallel to the sensor normal.

4. The encoder of any preceding claim, wherein:

the sensor is configured so that the magnetically free layer is saturated, such that a magnetization of the magnetically free layer is substantially aligned with the magnetic field provided by the magnetic scale, for all positions of the read head relative to the magnetic scale; and/or

the direction of the magnetic field provided by the magnetic scale in the plane of the magnetically free layer varies continuously as a function of position along the reference path at substantially all positions of the read head relative to the magnetic scale.

5. The encoder of any preceding claim, wherein the sensor comprises a magnetoresistance sensor in which the output of the sensor is a function of an electrical resistivity of a layer between the magnetically pinned layer and the magnetically free layer, the electrical resistivity being a function of the relative directions of magnetization in the magnetically free layer and the magnetically pinned layer, the sensor optionally comprising one or more of the following: an anisotropic magnetoresistance sensor, AMR; a giant magnetoresistance sensor, GMR; and a tunnel magnetoresistance sensor, TMR.

6. The encoder of any preceding claim, wherein the read head comprises a plurality of the sensors.

7. The encoder of claim 6, wherein the directions of magnetization in the magnetically pinned layers of all or a subset of the sensors provided at different positions in the read head along the reference path are parallel to each other.

8. The encoder of claim 6 or 7, wherein the magnetic scale comprises a periodic magnetic arrangement that repeats along the reference path, optionally comprising regions of opposite magnetization that alternate along the reference path.

9. The encoder of any of claims 6-8, wherein:

the sensors are provided at different positions in the read head along the reference path and are spaced apart evenly along the reference path; and

a pitch of the periodic magnetic arrangement is an integer multiple of a pitch of the evenly spaced sensors.

10. The encoder of claim 9, further comprising a Wheatstone bridge arrangement configured to compare outputs from different sensors, preferably from sensors that are spaced apart from each other by a pitch of the periodic magnetic arrangement, wherein the plurality of sensors optionally comprises at least four sensors and the integer multiple is four.

11. The encoder of claim 6, wherein the directions of magnetization in the magnetically pinned layers of at least two of the sensors are different to each other.

**12.** The encoder of claim 11, wherein the directions of magnetization in the magnetically pinned layers include at least two directions that are antiparallel to each other and/or at least two directions that are perpendicular to each other, optionally wherein the directions of magnetization include the following in a plane of each magnetically pinned layer relative to a reference axis: 0 degrees, 90 degrees, 180 degrees, 270 degrees.

**13.** The encoder of any of claims 11-12, wherein:

the magnetic scale comprises a periodic magnetic arrangement that repeats along the reference path; and
two or more of the sensors with different directions of magnetization in the magnetically pinned layers are all positioned within a length along the reference path that is smaller than a pitch of the periodic magnetic arrangement.

**14.** The encoder of any of claims 11-13, wherein two or more of the sensors with different directions of magnetization in the magnetically pinned layers are all positioned in the read head at substantially the same location along the reference path.

**15.** A method of detecting translational and/or rotational displacement of a read head relative to a magnetic scale, wherein:

the magnetic scale provides a magnetic field that varies as a function of position along a reference path relative to the magnetic scale;
the read head comprises a sensor that detects an amount of displacement of the read head relative to the magnetic scale by detecting a magnetic field;
the sensor comprises a stack of layers having at least a magnetically pinned layer and a magnetically free layer, an output of the sensor being dependent on an angle between a magnetization in the magnetically pinned layer and a magnetization in the magnetically free layer; and
a sensor normal, defined as a normal to planes of layers in the stack, is non-parallel to a local scale normal, defined as a normal to a portion of the magnetic scale facing the read head.

# Fig. 1

# Fig. 2

# Fig. 3

# Fig. 4

# Fig. 5

# Fig. 6

# Fig. 7

# Fig. 8

# Fig. 9

Europäisches
Patentamt

European
Patent Office

Office européen
des brevets

# EUROPEAN SEARCH REPORT

Application Number

EP 20 20 8079

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/115941 A1 (SHIMAUCHI HIDEKI [JP] ET AL) 30 April 2015 (2015-04-30) | 1,2,4-8,15 | INV. G01D5/14 |
| Y | * paragraph [0065] - paragraph [0067] * * figures 11-13B * | 3 | G01D5/244 G01R33/09 |
| | ----- | | |
| X | EP 2 330 389 A2 (TDK CORP [JP]) 8 June 2011 (2011-06-08) * paragraph [0022] - paragraph [0039] * * figures 1A-1C * | 1,11-15 | |
| | ----- | | |
| X | US 2009/251830 A1 (KURATA KOJI [JP] ET AL) 8 October 2009 (2009-10-08) * paragraph [0042] - paragraph [0050] * * figures 1,5 * | 1,9,10,15 | |
| | ----- | | |
| Y | US 2020/348373 A1 (UEDA KUNIHIRO [JP] ET AL) 5 November 2020 (2020-11-05) * paragraph [0010] - paragraph [0014] * * paragraph [0050] - paragraph [0052] * * figures 1-7 * | 3 | |
| | ----- | | TECHNICAL FIELDS SEARCHED (IPC) G01D G01R |

The present search report has been drawn up for all claims

| Place of search | Date of completion of the search | Examiner |
|---|---|---|
| Munich | 19 March 2021 | Paraf, Edouard |

EPO FORM 1503 03.82 (P04C01)

## ANNEX TO THE EUROPEAN SEARCH REPORT
## ON EUROPEAN PATENT APPLICATION NO.

EP 20 20 8079

This annex lists the patent family members relating to the patent documents cited in the above-mentioned European search report.
The members are as contained in the European Patent Office EDP file on
The European Patent Office is in no way liable for these particulars which are merely given for the purpose of information.

19-03-2021

| Patent document cited in search report | | Publication date | Patent family member(s) | | Publication date |
|---|---|---|---|---|---|
| US 2015115941 | A1 | 30-04-2015 | DE 102014214677 | A1 | 30-04-2015 |
| | | | JP 5721804 | B2 | 20-05-2015 |
| | | | JP 2015087137 | A | 07-05-2015 |
| | | | US 2015115941 | A1 | 30-04-2015 |
| EP 2330389 | A2 | 08-06-2011 | CN 102109359 | A | 29-06-2011 |
| | | | EP 2330389 | A2 | 08-06-2011 |
| | | | JP 5013146 | B2 | 29-08-2012 |
| | | | JP 2011137796 | A | 14-07-2011 |
| | | | US 2011133724 | A1 | 09-06-2011 |
| US 2009251830 | A1 | 08-10-2009 | DE 112007003178 | T5 | 26-11-2009 |
| | | | JP WO2008081797 | A1 | 30-04-2010 |
| | | | US 2009251830 | A1 | 08-10-2009 |
| | | | WO 2008081797 | A1 | 10-07-2008 |
| US 2020348373 | A1 | 05-11-2020 | CN 106019183 | A | 12-10-2016 |
| | | | DE 102016102413 | A1 | 29-09-2016 |
| | | | JP 6107864 | B2 | 05-04-2017 |
| | | | JP 2016183904 | A | 20-10-2016 |
| | | | US 2016282146 | A1 | 29-09-2016 |
| | | | US 2018364316 | A1 | 20-12-2018 |
| | | | US 2020348373 | A1 | 05-11-2020 |

EPO FORM P0459

For more details about this annex : see Official Journal of the European Patent Office, No. 12/82

**REFERENCES CITED IN THE DESCRIPTION**

**Patent documents cited in the description**

- US 141660